# EUROPEAN PATENT SPECIFICATION

(11) **EP 2 811 512 B1**
(45) Date of publication and mention of the grant of the patent: **02.10.2019**
(21) Application number: 12864126.3
(22) Date of filing: 10.12.2012
(51) Int. Cl.: H01L 23/13, H01L 23/12, H05K 1/02, C04B 35/645, C04B 37/02, H01L 23/373, H05K 1/03, H05K 3/38

(54) **CIRCUIT BOARD, AND ELECTRONIC DEVICE USING SAME**
LEITERPLATTE UND ELEKTRONISCHE VORRICHTUNG DAMIT
CARTE DE CIRCUIT IMPRIMÉ ET DISPOSITIF ÉLECTRONIQUE UTILISANT CELLE-CI

(30) Priority: 07.01.2012 JP 2012001702
(43) Date of publication of application: 10.12.2014
(73) Proprietor: Kyocera Corporation, Kyoto-shi, Kyoto 612-8501 (JP)
(72) Inventor: NIINO,Noritaka, Kyoto-shi Kyoto 612-8501 (JP)
(74) Representative: Viering, Jentschura & Partner mbB Patent- und Rechtsanwälte
(86) International application number: PCT/JP2012/081910
(87) International publication number: WO 2013/103066

(56) References cited:
- JP-A- H05 201 777
- JP-A- H07 330 454
- JP-A- H08 241 941
- JP-A- 2003 168 770
- JP-A- 2003 168 770
- JP-A- 2006 100 640
- WOO-CHUN LEE: "JOINING OF NICKEL-BASED INCONEL 600 ALLOY TO ALUMINA USING AG-CU-TIALLOY AND SOFT METALS", JOURNAL OF MATERIALS SCIENCE LETTERS, CHAPMAN AND HALL LTD. LONDON, GB, vol. 15, no. 1, 1 January 1996 (1996-01-01), pages 29-31, XP000552014, ISSN: 0261-8028, DOI: 10.1007/BF01855601

## Description

### Technical Field

The present invention relates to a circuit board on which an electronic component is mounted and an electronic device using the same.

### Background Art

As a circuit board to be used in an electronic device on which electronic components such as insulated gate bipolar transistors (IGBT) including a power module and a switching module are mounted, a circuit board in which a metal plate made of copper or aluminum is bonded to a ceramic board is used. The metal plate includes an electronic component mounting region, is electrically connected with a heat radiation plate for transferring or radiating heat from an electronic component and with the electronic component, and functions as a metal circuit board for wiring. The electronic component is mounted in the electronic component mounting region of the metal plate, and is electrically bonded to the metal circuit board on the ceramic board by a bonding wire, for example.

### Citation List

### Patent Literature

PTL 1: Japanese Unexamined Patent Application Publication No. 2002-110872

JP 2003 168770 A discloses a silicon nitride circuit board, wherein a metal clad which is at least 1 mm thick is jointed to at least one surface of a silicon nitride substrate.

"Joining of nickel-based Inconel 600 alloy to alumina using Ag-Cu-Ti alloy and soft metals" (WOO-CHUN LEE, JOURNAL OF MATERIALS SCIENCE LETTERS, CHAPMAN AND HALL LTD. LONDON, GB, vol. 15, no.1, 1 January 1996 (1996-01-01), pages 29-31, XP 000552014, ISSN: 0261-8028, DOI: 10.1007/BF01855601) discloses the joining of Ni-Cr-Fe Inconel 600 alloy to alumina using Ag-27Cu-3Ti alloy. This document further discloses that five types of insert materials, i.e. copper, niobium, titanium, molybdenum, and nickel, with Ag-Cu-Ti alloys are used between alumina and Inconel 600 alloy.

H05-201777 A discloses that a ceramic-metal joined body is made by joining a metal member to a nitride base ceramic member with an Ag-Cu brazing material layer containing at least one kind of an active metal selected among Ti, Zr and Nb.

JP 2006 100640 A discloses a heat radiation plate made of a clad material in three-layer structure of Cu, Mo, and Cu, or Cu, W, and Cu provided on one main surface of a ceramic substrate. On the other main surface, a circuit board made of Cu or Cu alloy is provided.

### Summary of Invention

### Technical Problem

A circuit board in which a metal plate and a ceramic board are bonded with each other via a brazing material has a problem that the metal plate is detached from the ceramic board in some cases due to a difference between a coefficient of thermal expansion of the metal plate and a coefficient of thermal expansion of the ceramic board. Solution to Problem

The present invention provides a circuit board as defined in claim 1. Further embodiments of the present invention are described in the dependent claims. Accordingly, a circuit board includes a ceramic board, a metal layer on the ceramic board, and a metal plate on the metal layer. The metal layer includes a first metal portion which is in contact with the ceramic board, a second metal portion which is in contact with the metal plate, and a third metal portion between the first metal portion and the second metal portion. A part of the first metal portion extends toward a direction of the second metal portion such that the part of the first metal portion penetrates the third metal portion. The part of the first metal portion spreads out in a lateral direction along the second metal portion.

According to another aspect of the invention, an electronic device includes the circuit board with the above-described configuration and an electronic component mounted on the metal plate of the circuit board.

### Advantageous Effects of Invention

According to the one aspect of the present invention, in a circuit board, a part of a first metal portion extends toward a direction of a second metal portion such that the part of the first metal portion penetrates a third metal portion, and spreads out in a lateral direction along the second metal portion. Accordingly, the first metal portion is hooked onto the third metal portion. As a result, a bond between a metal plate and a ceramic board is solidified, and thus the metal plate can be difficult to be detached from the ceramic board, and the circuit board with good long-term reliability can be provided.

According to the another aspect of the present invention, since an electronic device includes the circuit board with the above-described configuration and an electronic component mounted on the metal plate of the circuit board, the electronic device having a good long-term reliability is provided.

### Brief Description of Drawings

Fig. 1 is a cross-sectional view illustrating an electronic device according to a first embodiment of the present invention.
Fig. 2 is an enlarged cross-sectional view of Part A of Fig. 1.
Fig. 3 is a view illustrating a method for manufacturing the circuit board of the first embodiment of the present invention.
Fig. 4 is an enlarged cross-sectional view illustrating the electronic device according to the first embodiment of the present invention.
Fig. 5 is an enlarged cross-sectional view illustrating the electronic device according to a second embodiment of the present invention.

### Description of Embodiments

Several exemplary embodiments of the present invention will be described with reference to the attached drawings.

### (First Embodiment)

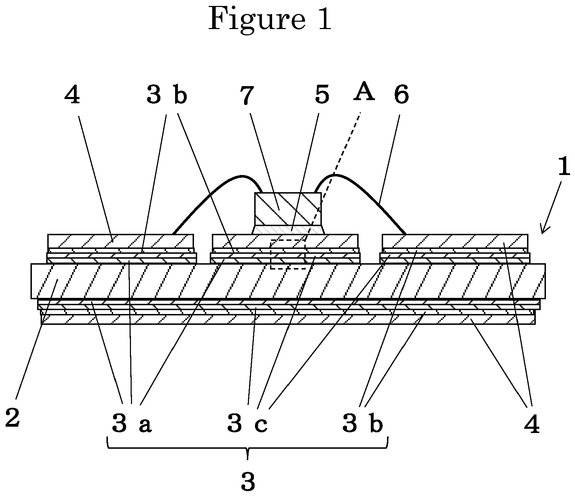

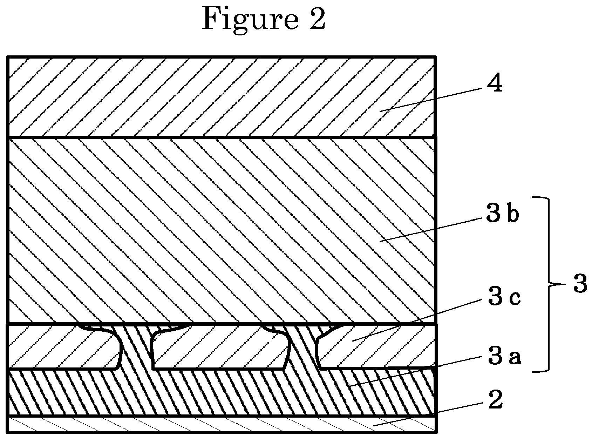

An electronic device according to a first embodiment of the present invention includes a circuit board 1 and an electronic component 7 mounted on the circuit board 1 as illustrated in Figs. 1 and 2.

The circuit board 1 includes a ceramic board 2 and a metal plate 4 on the ceramic board 2 via a metal layer 3.

The ceramic board 2 is in a substantially rectangular shape, and functions as a support member which supports the metal plate 4. The ceramic board 2 is made of an electric insulation material, for example, ceramics, such as aluminum oxide based ceramics, mullite based ceramics, silicon carbide based ceramics, aluminum nitride based ceramics, or silicon nitride based ceramics. Among the ceramics materials, from viewpoint of heat conductivity that affects heat radiation, the silicon carbide based ceramics, the aluminum nitride based ceramics, or the silicon nitride based ceramics are preferable. From viewpoint of strength, the silicon nitride based ceramics or the silicon carbide based ceramics are preferable. In a case where the ceramic board 2 is made of a ceramic material having comparatively high strength, such as the silicon nitride based ceramics, since a possibility of occurrence of cracks on the ceramic board 2 is reduced even when a thicker metal plate 4 is used, it is possible to realize the circuit board 1 in which higher electric current can flow while making the size thereof smaller.

When the ceramic board 2 is thin, for example, approximately 0.1 mm to 1 mm, the ceramic board 2 has good heat conductivity. The thickness of the ceramic board 2 may be selected according to a size of the circuit board 1 or thermal conductivity or strength of the material to be used in the circuit board 1.

If the ceramic board 2 is made of silicon nitride based ceramics, a slurry is made by adding and mixing an appropriate organic binder, a plasticizer, and a solvent to raw material powder, such as silicon nitride, aluminum oxide, magnesium oxide, and yttrium oxide. By using the slurry, a ceramic green sheet (ceramic raw sheet) is formed by employing a doctor blade method or calendar roll method which are known methods. Next, a punching process appropriate to the ceramic green sheet is performed, and a predetermined shape is obtained. When necessary, a plurality of sheets are layered to be a molded body. After that, in a non-oxidizing atmosphere, such as a nitrogen atmosphere, the molded body is fired in a temperature range of 1,600°C to 2,000°C to manufacture the ceramic board 2.

The metal layer 3 includes a first metal portion 3a, a second metal portion 3b, and a third metal portion 3c.

The first metal portion 3a is in contact with the ceramic board 2. In a heated state, the first metal portion 3a spreads out toward the third metal portion 3c, and does not spread out toward the second metal portion 3b.

In a heated state, the first metal portion 3a spreads out toward the third metal portion 3c which is in a melted state, but does not spread out toward the second metal portion 3b which is not in a melted state. The second metal portion 3b which stops the spread of the first metal portion 3a has a melting point higher than the first metal portion 3a and the third metal portion 3c.

The first metal portion 3a is made of a brazing material which bonds the third metal portion 3c, the second metal portion 3b, and the metal plate 4 to the ceramic board 2.

According to the present invention, the first metal portion 3a includes silver as a main component and is formed by a paste made of a silver brazing material. Examples of the brazing material include an active brazing material that includes a silver brazing material (for example, silver: 72 mass% and copper: 28 mass%) of which a main component is silver and at least one of active metal selected from titanium, hafnium, and zirconium is contained. In addition, the main component represents a component which is contained most among the plurality of components.

The second metal portion 3b is in contact with the metal plate 4. When the metal plate 4 is bonded to the ceramic board 2, the second metal portion 3b stops the spread of the silver which is the main component of the first metal portion 3a to the metal plate 4 side, and causes the silver to spread out in the lateral direction when viewed from a longitudinal section. As the second metal portion 3b, it is possible to use a material which has a higher melting point than the first metal portion 3a and the third metal portion 3c.

The second metal portion 3b, from viewpoint of the heat conductivity (heat dissipation effect), includes as a main component any one of molybdenum, tungsten, and invar.

In addition, it is preferable that the second metal portion 3b use a material which has a coefficient of thermal expansion lower than the first metal portion 3a and the third metal portion 3c.

The third metal portion 3c is disposed between the first metal portion 3a and the second metal portion 3b. A main component of the third metal portion 3c is copper or aluminum. When heating is performed to bond the metal plate by the first metal portion 3a (brazing material), the brazing material can spread out to the third metal portion 3c.

The metal plate 4 is fixed to at least one main surface (an upper surface or a lower surface) of the ceramic board 2. The metal plate 4 functions as a heat radiation plate for radiating the heat generated by the electronic component 7 on the metal plate 4, or as a metal circuit board which is electrically connected with the electronic component 7.

From viewpoint of the heat radiation, a metal material having high heat conductivity is used for the metal plate 4. According to the present invention, the metal plate 4 includes copper or aluminum as a main component. For example, copper as a metal material having high heat conductivity is used (heat conductivity of copper: 395 W/m·K). By performing a metal processing method, such as a mechanical process including a rolling process or a punching process, or a chemical process including etching to a copper ingot (lump), the metal plate 4 is formed in a predetermined pattern in a flat board shape having a thickness of 0.05 mm to 1 mm. In addition, in order to suppress thermal expansion, the metal plate 4 may use a metal material, such as molybdenum having a coefficient of thermal expansion lower than copper, and may have a structure in which the copper and molybdenum are overlapped in a plurality of layers. In addition, as illustrated in Fig. 1, it is preferable that the metal plate 4 on the lower surface of the ceramic board 2 be substantially entirely disposed on the lower surface of the ceramic board 2, and the heat radiation of the electronic component 7 on the circuit board 1 be enhanced.

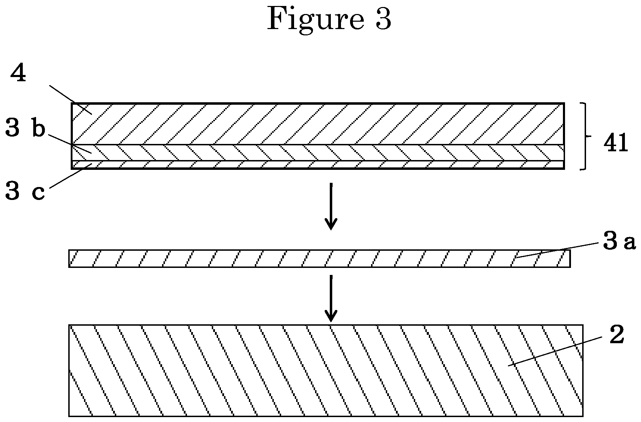

A method for bonding the third metal portion 3c, the second metal portion 3b, and the metal plate 4 to the ceramic board 2 will be described in detail with reference to Fig. 3.

First, as illustrated in Fig. 3, a metal member 41, which includes the metal plate 4, the second metal portion 3b on the lower surface of the metal plate 4, and the third metal portion 3c on the lower surface of the second metal portion 3b, is manufactured. In other words, the metal member 41 includes the metal plate 4, the second metal portion 3b, and the third metal portion 3c.

As a method for manufacturing the metal member 41, first, the metal plate made of molybdenum to be the second metal portion 3b and the metal plate made of copper to be the metal plate 4 are integrated by the rolling process. Then, the metal processing method, such as the mechanical process including the punching process, or the chemical process including etching, is performed on the integrated second metal portion 3b and the metal plate 4, and the integrated second metal portion 3b and the metal plate 4 are processed to have predetermined dimensions. After that, the third metal portion 3c made of copper is adhered to a main surface of the second metal portion 3b where the metal plate 4 is not provided, among the main surfaces thereof, by a plating method or a vacuum deposition method. In this manner, the metal member 41 is manufactured to have three layers of copper-molybdenum-copper.

In addition, the metal plate 4 may be a plate made of laminated copper and molybdenum, for example, and may have two layers of copper-molybdenum or four layers of copper-molybdenum-copper-molybdenum. In such case, the coefficient of thermal expansion of the metal plate 4 is reduced so that a difference between the coefficient of thermal expansion of the metal plate 4 and the coefficient of thermal expansion of the ceramic board 2 can be reduced.

In addition, it is preferable that the material of the third metal portion 3c be oxygen-free copper. If the third metal portion 3c is oxygen-free copper, when the metal member 41 and the ceramic board 2 are bonded to each other, it is possible to reduce the oxidation of the surface of the third metal portion 3c caused by the oxygen in the third metal portion 3c, and wettability between the third metal portion 3c and the silver brazing material which forming the first metal portion 3a is improved.

Next, on a bonding surface of at least one of the third metal portion 3c and the ceramic board 2, a paste made of the silver brazing material is printed and applied by screen printing or the like with a thickness of 30 µm to 50 µm in a predetermined pattern.

The paste made of the silver brazing material is manufactured by adding and mixing 2 mass% to 5 mass%, with respect to the silver brazing material, of an active metal such as titanium, hafnium, zirconium, or hydride thereof to silver brazing material powder made of, for example, silver and copper powder, silver-copper alloy powder, or mixed powder thereof (for example, when the metal plate and the third metal portion include copper as the main component, silver is 72 mass% and copper is 28 mass%), and by adding, mixing, and kneading the appropriate binder, the organic solvent, and dissolvent. A temperature of bonding the above-described silver brazing material is 780°C to 900°C, but indium (In) or tin (Sn) may be added by substantially 1 mass% to 10 mass% for reducing the bonding temperature or hardness of the silver brazing material (first metal portion 3a). When the metal plate 4 and the third metal portion 3c include aluminum as the main component, bonding is performed at the bonding temperature of 600°C, and the silver brazing material having a melting point lower than the bonding temperature is used.

In addition, after disposing the metal member 41 on the ceramic board 2 to have a predetermined structure, the metal member 41 and the ceramic board 2 are heated at 780°C to 900°C for 10 to 40 minutes in a vacuum or in a non-oxidizing atmosphere, while a load of 5 kPa to 10 kPa is applied thereto. At that time, by the heating, the silver brazing material spreads out toward copper of the third metal portion 3c, and extends toward the second metal portion 3b such that the silver brazing material penetrates the third metal portion 3c. Furthermore, the spread of the silver brazing material is blocked by the second metal portion 3b, and the silver brazing material spreads out in a lateral direction along the second metal portion 3b. In this manner, as illustrated in Fig. 2, the first metal portion 3a and the third metal portion 3c are formed such that, when viewed from the longitudinal section, the first metal portion 3a which has silver as the main component is hooked onto the third metal portion 3c which has copper as the main component.

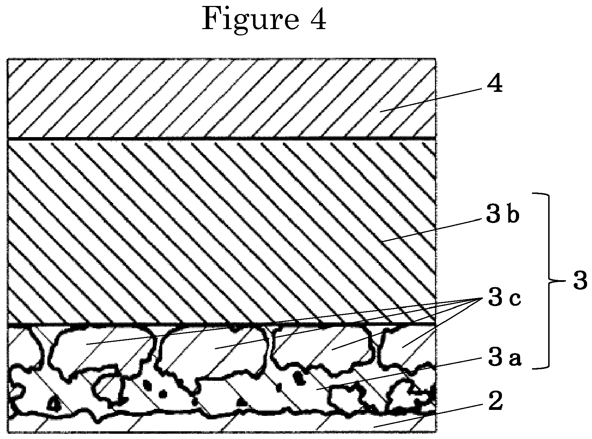

In addition, since a part of the third metal portion 3c spreads out toward the silver brazing material, the first metal portion 3a and the third metal portion 3c spread out alternately. Therefore, as illustrated in Fig. 4, the first metal portion 3a and the third metal portion 3c are formed such that, when viewed from the longitudinal section, a part of the third metal portion 3c spreads out into the first metal portion 3a. In addition, the third metal portion 3c may include a part of the silver brazing material.

In addition, when viewed from the longitudinal section, parts of the portions of the first metal portion 3a which spread out in the lateral direction along the second metal portion 3b may be connected to each other. In this case, since it is possible to strengthen the hooked state of the first metal portion 3a onto the third metal portion 3c, it is possible to improve the bonding strength between the first metal portion 3a and the third metal portion 3c.

Such structure can be obtained by utilizing a higher temperature or longer heating time when the metal member 41 and the ceramic board 2 are bonded. For example, the structure can be obtained by heating the metal member 41 and the ceramic board 2 at 860°C to 960°C, or for 50 to 120 minutes.

After bonding the metal member 41 to the ceramic board 2, when the metal member 41 is processed in the predetermined pattern by etching, for example, the following method is used. After printing and applying an etching resist ink on the surface of the metal member 41 bonded to the ceramic board 2 by using a technique, such as a screen printing method, and forming a resist film, portions other than the predetermined pattern of the metal member 41 are removed by dipping the member into an etchant including one or combination of phosphoric acid solution, acetic acid solution, nitric acid solution, hydrogen peroxide solution, sulfuric acid solution, hydrofluoric acid solution, ferric chloride solution, cupric chloride solution, or the like, or by spraying the etchant. After that, a resist film may be removed. In addition, before bonding the metal member 41 to the ceramic board, the metal member 41 may be processed to have the predetermined pattern by using the above-described method or by the mechanical process, such as the punching process.

In addition, when a metal having high conductivity, high corrosion resistance, and high wettability with the brazing material is adhered to the metal member 41 bonded to the ceramic board 2 by the plating method, an electrical connection between the metal plate 4 and an outer electric circuit (not illustrated) can be good. In this case, it is preferable that the metal be a nickel-phosphorus amorphous alloy containing 8 mass% to 15 mass% of phosphorus, since it is possible to maintain a wettability with the brazing material for a long period by suppressing oxidation of the surface of the plating layer made of nickel. When a content of phosphorus with respect to nickel is 8 mass% or more and 15 mass% or less, it is easy to form the nickel-phosphorus amorphous alloy, and it is possible to improve the adhesion strength of solder with respect to the plating layer. When a thickness of the plating layer made of the nickel is 1.5 µm or more, it is easy to coat an exposed surface of the second metal portion 3b and the metal plate 4, and it is possible to suppress the oxidation and corrosion of the second metal portion 3b and the metal plate 4. In addition, when the thickness is 10 µm or less, and particularly, when the thickness of the ceramic board 2 is less than 300 µm, it is possible to reduce an inherent stress inside the plating layer, and to reduce a bend caused in the metal member 41, and a bend or a crack in the ceramic board 2 caused due to the bend in the metal member 41.

The electronic device is configured by mounting the electronic component 7 on the upper surface of the circuit board 1 formed as described above via a die bond material 5, and by electrically connecting the electronic component 7 to the metal plate 4 which is used as the metal circuit board by a plurality of bonding wires 8. In addition, the die bond material 5 is made of, for example, a metal bonding material or conductive resin. Examples of the metal bonding material include solder, gold-tin (Au-Sn) alloy, or tin-silver-copper (Sn-Ag-Cu) alloy. The electronic component 7 is a semiconductor element, such as a transistor, a large scale integrated (LSI) circuit for a central processing unit (CPU), an insulated gate bipolar transistor (IGBT), or a metal oxide semiconductor - field effect transistor (MOS-FET) .

In the electronic device of the embodiment, the circuit board 1 includes the ceramic board 2 and the metal plate 4 on the ceramic board 2 via the metal layer 3. The metal layer 3 includes the first metal portion 3a which is in contact with the ceramic board 2, the second metal portion 3b which is in contact with the metal plate 4, and the third metal portion 3c between the first metal portion 3a and the second metal portion 3b. A part of the first metal portion 3a extends toward the direction of the second metal portion 3b to penetrate the third metal portion 3c, and spreads out in a lateral direction along the second metal portion 3b. Accordingly, the first metal portion 3a is hooked onto the third metal portion 3c. As a result, the bond between the metal plate 4 and the ceramic board 2 is solidified, and thus the metal plate 4 is not easily detached from the ceramic board 2, and the circuit board with good long-term reliability can be provided.

In the case of the circuit board 1 of the embodiment, in the above-described configuration, in a case where the third metal portion 3c is made of a material which has higher melting point than the first metal portion 3a, when the first metal portion 3a and the third metal portion 3c are bonded to each other, since an excessive melting of the third metal portion 3c can be reduced, it is possible to reduce deterioration of the bonding strength between the third metal portion 3c and the second metal portion 3b.

In the case of the circuit board 1 of the embodiment, in the above-described configuration, the first metal portion 3a includes silver, the third metal portion 3c includes copper or aluminum, the second metal portion 3b includes any one of molybdenum, tungsten, and invar, and the metal plate 4 includes copper or aluminum as the main component, respectively. Therefore, it is possible to improve the heat conductivity of the third metal portion 3c and the metal plate 4. In addition, when the first metal portion 3a and the third metal portion 3c are bonded to each other, the first metal portion 3a is likely to spread out toward the third metal portion 3c, and is not likely to spread out toward the second metal portion 3b. Therefore, the hooked portion of the first metal portion 3a onto the third metal portion 3c increases, and it is possible to improve the bonding strength between the first metal portion 3a and the third metal portion 3c.

In the case of the circuit board 1 of the embodiment, in the above-described configuration, when the third metal portion 3c and the metal plate 4 include the same metal material as the main component, the difference of the thermal expansion between the third metal portion 3c and the metal plate 4 can be reduced. Therefore, via thermal stress generated by the difference of the thermal expansion between the third metal portion 3c and the metal plate 4, it is possible to reduce the bend caused by the second metal portion 3b.

Since the electronic device of the embodiment includes the circuit board 1 having the above-described configuration and the electronic component 7 mounted on the metal plate 4 of the circuit board 1, it is possible to obtain the electronic device with a good long-term reliability.

### (Second Embodiment)

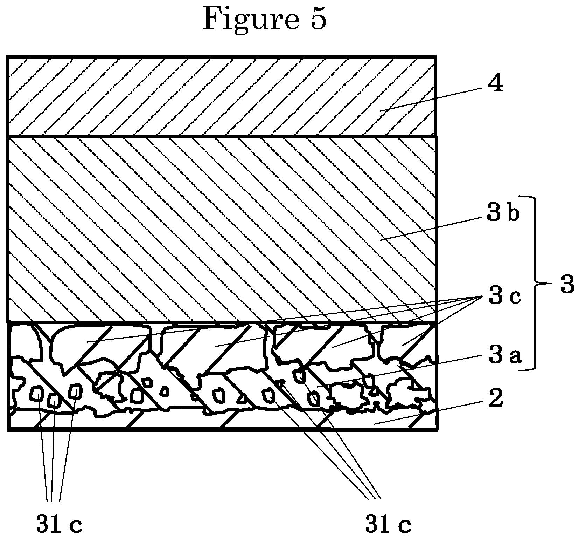

Next, an electronic device according to the second embodiment of the present invention will be described with reference to Fig. 5.

The electronic device according to the embodiment is different from the electronic device of the above-described first embodiment in that the first metal portion 3a includes a first metal body and a plurality of second metal bodies 31c scattered inside the first metal body, and the plurality of second metal bodies 31c and the third metal portion 3c include the same metal material as the main component. In this case, since it is possible to make the coefficients of thermal expansion of the first metal portion 3a and the third metal portion 3c close to each other, it is possible to reduce the difference of the thermal expansion between the first metal portion 3a and the third metal portion 3c, and to reduce detachment between the first metal portion 3a and the third metal portion 3c.

In addition, as compared to the circuit board of the first embodiment, the circuit board of the embodiment can be obtained by making the temperature higher, by making the heating time longer, or by adding a metal material having a low melting point to the brazing material, when the metal member 41 and the ceramic board 2 are bonded to each other. For example, the circuit board can be made by setting the temperature of the metal member 41 and the ceramic board 2 to 860°C to 960°C. In addition, the circuit board can be made by setting the heating time to 50 to 120 minutes. In addition, the circuit board can be made by adding 5 mass% to 10 mass% of a metal material having a low melting point, such as indium (In) or tin (Sn).

### Reference Signs List

- 1: Circuit board
- 2: Ceramic board
- 3a: First metal portion
- 3b: Second metal portion
- 3c: Third metal portion
- 31c: Second metal body
- 4: Metal plate
- 41: Metal member

## Claims

1. A circuit board (1), comprising:
a ceramic board (2);
a metal layer (3) on the ceramic board (2); and
a metal plate (4) on the metal layer (3),
wherein the metal layer (3) includes:
a first metal portion (3a) which is in contact with the ceramic board (2),
a second metal portion (3b) which is in contact with the metal plate (4), and
a third metal portion (3c) between the first metal portion (3a) and the second metal portion (3b), and
a part of the first metal portion (3a) extends toward a direction of the second metal portion (3b) such that the part of the first metal portion (3a) penetrates the third metal portion (3c), and
the part of the first metal portion (3a) spreads out in a lateral direction along the second metal portion (3b);
wherein the first metal portion (3a) includes silver as a main component and is formed by a paste made of a silver brazing material printed and applied with a thickness of 30 µm to 50 µm in a predetermined pattern,
wherein the third metal portion (3c) includes copper or aluminum as a main component, and
wherein the second metal portion (3b) includes any one of molybdenum, invar, and tungsten as a main component, and the metal plate (4) includes copper or aluminum as a main component.

2. The circuit board (1) according to Claim 1,
wherein the second metal portion (3b) is made of a material having a melting point higher than melting points of the first metal portion (3a) and the third metal portion (3c) .

3. The circuit board (1) according to Claim 1 or 2,
wherein the first metal portion (3a) includes a first metal body and a plurality of second metal bodies (31c) scattered inside the first metal body, and
wherein the plurality of second metal bodies (31c) and the third metal portion (3c) include the same metal material as the main component.

4. The circuit board (1) according to any one of Claims 1 to 3,
wherein the third metal portion (3c) and the metal plate (4) include the same metal material as the main component.

5. An electronic device, comprising:
the circuit board (1) according to any one of Claims 1 to 4; and
an electronic component (7) mounted on the metal plate (4) of the circuit board (1).

## Patentansprüche

1. Eine Leiterplatte (1), aufweisend:
eine Keramikplatte (2),
eine Metallschicht (3) auf der Keramikplatte (2) und
eine Metallplatte (4) auf der Metallschicht (3),
wobei die Metallschicht (3) aufweist:
einen ersten Metallabschnitt (3a), der mit der Keramikplatte (2) in Kontakt ist,
einen zweiten Metallabschnitt (3b), der mit der Metallplatte (4) in Kontakt ist, und
einen dritten Metallabschnitt (3c) zwischen dem ersten Metallabschnitt (3a) und dem zweiten Metallabschnitt (3b), und
ein Teil des ersten Metallabschnitts (3a) sich in Richtung des zweiten Metallabschnitts (3b) erstreckt, so dass der Teil des ersten Metallabschnitts (3a) den dritten Metallabschnitt (3c) durchdringt, und
der Teil des ersten Metallabschnitts (3a) sich in einer seitlichen Richtung entlang des zweiten Metallabschnitts (3b) ausbreitet,
wobei der erste Metallabschnitt (3a) Silber als einen Hauptbestandteil aufweist und durch eine aus einem Silberlötmaterial hergestellte Paste gebildet ist, die aufgedruckt und mit einer Dicke von 30 µm bis 50 µm in einem vorbestimmten Muster aufgebracht ist,
wobei der dritte Metallabschnitt (3c) Kupfer oder Aluminium als einen Hauptbestandteil aufweist, und
wobei der zweite Metallabschnitt (3b) irgendeines von Molybdän, Invar und Wolfram als einen Hauptbestandteil aufweist und die Metallplatte (4) Kupfer oder Aluminium als einen Hauptbestandteil aufweist.

2. Die Leiterplatte (1) gemäß Anspruch 1,
wobei der zweite Metallabschnitt (3b) aus einem Material mit einem Schmelzpunkt hergestellt ist, der höher als Schmelzpunkte des ersten Metallabschnitts (3a) und des dritten Metallabschnitts (3c) ist.

3. Die Leiterplatte (1) gemäß Anspruch 1 oder 2,
wobei der erste Metallabschnitt (3a) einen ersten Metallkörper und eine Mehrzahl von zweiten Metallkörpern (31c) aufweist, die innerhalb des ersten Metallkörpers verstreut sind, und
wobei die Mehrzahl von zweiten Metallkörpern (31c) und der dritte Metallabschnitt (3c) das gleiche Metallmaterial als Hauptbestandteil aufweisen.

4. Die Leiterplatte (1) gemäß irgendeinem der Ansprüche 1 bis 3,
wobei der dritte Metallabschnitt (3c) und die Metallplatte (4) das gleiche Metallmaterial als Hauptbestandteil aufweisen.

5. Eine elektronische Vorrichtung, aufweisend:
die Leiterplatte (1) gemäß irgendeinem der Ansprüche 1 bis 4 und
ein elektronisches Bauelement (7), das auf der Metallplatte (4) der Leiterplatte (1) montiert ist.

## Revendications

1. Une carte de circuit (1), comprenant
une plaque céramique (2) ;
une couche métallique (3) sur la plaque céramique (2) ;
et une plaque métallique (4) sur la couche métallique (3),
dans laquelle la couche métallique (3) comprend :
une première partie métallique (3a) qui est en contact avec la plaque céramique (2),
une deuxième partie métallique (3b) qui est en contact avec la plaque métallique (4), et
une troisième partie métallique (3c) entre la première partie métallique (3a) et la deuxième partie métallique (3b), et
une partie de la première partie métallique (3a) s'étend vers une direction de la deuxième partie métallique (3b) de sorte que la partie de la première partie métallique (3a) pénètre dans la troisième partie métallique (3c), et
la partie de la première partie métallique (3a) s'étend dans une direction latérale le long de la deuxième partie métallique (3b),
dans laquelle la première partie métallique (3a) comprend de l'argent comme composant principal et est formée par une pâte faite d'un matériau de brasage d'argent imprimée et appliquée avec une épaisseur de 30 µm à 50 µm selon un motif prédéterminé,
dans laquelle la troisième partie métallique (3c) comprend du cuivre ou de l'aluminium comme composant principal, et
dans laquelle la deuxième partie métallique (3b) comprend l'un quelconque parmi le molybdène, l'invar et le tungstène en tant que composant principal, et la plaque métallique (4) comprend le cuivre ou l'aluminium en tant que composant principal.

2. La carte de circuit (1) selon la revendication 1,
dans laquelle la deuxième partie métallique (3b) est constituée d'un matériau ayant un point de fusion supérieur à des points de fusion de la première partie métallique (3a) et de la troisième partie métallique (3c).

3. La carte de circuit (1) selon la revendication 1 ou 2,
dans laquelle la première partie métallique (3a) comprend un premier corps métallique et une pluralité de deuxièmes corps métalliques (31c) dispersés à l'intérieur du premier corps métallique, et
dans laquelle la pluralité de deuxièmes corps métalliques (31c) et la troisième partie métallique (3c) comprennent le même matériau métallique comme composant principal.

4. La carte de circuit (1) selon l'une quelconque des revendications 1 à 3,
dans laquelle la troisième partie métallique (3c) et la plaque métallique (4) comprennent le même matériau métallique comme composant principal.

5. Un dispositif électronique, comprenant :
la carte de circuit (1) selon l'une quelconque des revendications 1 à 4 ; et
un composant électronique (7) monté sur la plaque métallique (4) de la carte de circuit (1).
